(19) Europäisches Patentamt
European Patent Office
Office européen des brevets

(11) **EP 3 318 352 A1**

(12) **EUROPÄISCHE PATENTANMELDUNG**

(43) Veröffentlichungstag:
**09.05.2018   Patentblatt 2018/19**

(21) Anmeldenummer: **17001797.4**

(22) Anmeldetag: **03.11.2017**

(51) Int Cl.:
*B22F 3/105* (2006.01)   *B33Y 10/00* (2015.01)
*B33Y 50/02* (2015.01)   *B29C 64/00* (2017.01)
*B29C 64/386* (2017.01)   *G01N 29/44* (2006.01)
*G05B 19/418* (2006.01)   *G06F 17/50* (2006.01)
*G06T 17/20* (2006.01)   *G01N 11/00* (2006.01)

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**
Benannte Erstreckungsstaaten:
**BA ME**
Benannte Validierungsstaaten:
**MA MD**

(30) Priorität: **03.11.2016   DE 102016120998**

(71) Anmelder: **Amsis GmbH
28209 Bremen (DE)**

(72) Erfinder: **PLOSHIKHIN, Vasily
28209 Bremen (DE)**

(74) Vertreter: **Ellberg, Nils et al
Meissner Bolte Patentanwälte
Rechtsanwälte Partnerschaft mbB
Hollerallee 73
28209 Bremen (DE)**

(54) **VERFAHREN ZUR SIMULATIONSBASIERTEN ERKENNUNG THERMISCH KRITISCHER BAUTEILBEREICHE UND VERFAHREN ZUR BAUTEILSPEZIFISCHEN ANPASSUNG EINER LOKALEN WÄRMEGENERIERUNG BEI DER ADDITIVEN HERSTELLUNG**

(57)   Die Erfindung betrifft ein Verfahren zur simulationsbasierten Erkennung thermisch kritischer Bauteilbereiche bei der additiven Herstellung eines dreidimensionalen Bauteils (10) aus mehreren Bauteilschichten durch mehrfaches inkrementelles, insbesondere schichtweises, Hinzufügen von pulver-, draht- oder bandförmigem, insbesondere metallischem, Bauteilausgangsmaterial und, insbesondere inkrementelles, formgebendes Verfestigen durch jeweiliges selektives Schmelzen und/oder Sintern des Bauteilausgangsmaterials mittels einer durch mindestens eine Energiequelle lokal eingebrachten Wärmemenge, umfassend
- simulationsbasierte Berechnung der Werte der lokalen Wärmeableitungsfähigkeit in Bauteilschichten des hergestellten Bauteils (10), und
- Erkennung von thermisch kritischen Bauteilbereichen anhand der simulationsbasiert berechneten Werte der lokalen Wärmeableitungsfähigkeiten oder anhand einer Funktion derselben.

Ferner betrifft die Erfindung ein Verfahren nach den Ansprüchen 6 und 10.

Fig. 1

**Beschreibung**

Die vorliegende Erfindung betrifft ein Verfahren zur simulationsbasierten Erkennung thermisch kritischer Bauteilbereiche bei der additiven Herstellung eines dreidimensionalen Bauteils aus mehreren Bauteilschichten durch mehrfaches inkrementelles, insbesondere schichtweises, Hinzufügen von pulver-, draht- oder bandförmigem, insbesondere metallischem Bauteilausgangsmaterial und, insbesondere inkrementelles, formgebendes Verfestigen durch jeweiliges selektives Schmelzen und/oder Sintern des Bauteilausgangsmaterials mittels einer durch mindestens eine Energiequelle lokal eingebrachten Wärmemenge, sowie ein Verfahren zur bauteilspezifischen lokalen Anpassung, insbesondere Steuerung oder Regelung, einer lokalen Wärmegenerierung bei der vorgenannten additiven Herstellung eines dreidimensionalen Bauteils.

Mit "Bauteil" soll auch ein Bauteil inklusive Bauplatte (Basisplatte) und Stützstruktur(en) gemeint sein. Zudem soll der Begriff "Bauteil" auch einen Bauteil-Satz, wie z. B. ein in einem Baujob in einem Bauraum gefertigtes Konstrukt, das z. B. aus mehreren, z. B. identischen, Einzelbauteilen bestehen kann, umfassen.

Als Energiequelle (n) kann/können zum Beispiel ein Lichtbogen, ein Plasma bzw. Plasmastrahl, ein Laser- oder Elektronenstrahl oder ähnliches verwendet werden. Das additive Herstellungsverfahren kann insbesondere ein strahlbasiertes additives Herstellungsverfahren sein. Obwohl das Bauteilausgangsmaterial oben als metallisch bezeichnet ist, kann das Bauteil auch aus Kunststoff oder Keramik hergestellt werden.

Bei dem additiven Herstellungsverfahren, das auch als generatives Herstellungsverfahren bezeichnet wird, kann es sich beispielsweise um Lichtbogen-, Plasma-, Laser- und Elektronenstrahlauftragsschweißen und allgemeiner Auftragsschweißen, insbesondere Pulverauftragsschweißen, Laser- und Elektronenstrahlschmelzen, Lasersintern und alle weiteren Verfahren handeln, bei denen Material in der Schmelze zur Generierung eines Bauteils selektiv aufgetragen wird.

Die Wärmemenge wird dabei gemäß einer Scanstrategie eingebracht. Mit dem Begriff "Scanstrategie" soll hier in erster Linie die Beschreibung der Verfestigung eines definierten Querschnitts in einer Schicht aus einem Bauteilausgangsmaterial mittels mindestens einer bewegten (insbesondere punktförmigen) Energiequelle unter Berücksichtigung von Ablenkwegen bzw. Belichtungswegen (Scanmuster) und Strahlparametern sowie der Zeitabhängigkeit der Ablenkwege und Richtungsabhängigkeit der Ablenkwege zur Erzeugung gewünschter Bauteil- und Gefügeeigenschaften gemeint sein. Die Scanstrategie umfasst ein Scanmuster (englisch: scanning pattern). Dabei handelt es sich um die geometrische Beschreibung der Ablenkwege oder Verbindungslinien von aufeinander folgenden Energieeinträgen, wenn zum Beispiel gepulst wird, zur Verfestigung der Bauteilkontur und/oder des Bauteilquerschnitts mittels mindestens eines Strahls. Das Scanmuster kann ein Hatching umfassen. Zusätzlich zum Hatching kann es ein Outlining umfassen. Das "Outlining" ist dabei das konturparallele Abfahren der Außenlinie eines Bauteilquerschnitts mit dem Strahl. Das "Hatching" ist das Muster, nach welchem die anlageneigene Energieführung den Strahl ablenkt, um den Bauteilquerschnitt zu verfestigen. Die Beschreibung des Hatchings beinhaltet darüber hinaus die Unterteilung in Teilbereiche und deren Füllung mit (weiteren) Mustern.

Während eines additiven Herstellungsverfahrens können durch den schichtweisen Aufbau und die lokale Energieeinbringung, insbesondere in der Nähe von Bauteilrändern, Wärmestaus und insbesondere lokale Überhitzungen ("Hotspots") entstehen. Dies kann zu einer Beeinträchtigung der Bauteilqualität durch unerwünschte Deformationen des Bauteils währen des Aufbauprozesses und insbesondere zur Reduzierung der Oberflächenqualität des Bauteils aufgrund von Ansinterungseffekten führen.

Zur Erkennung thermisch kritischer Bauteilbereiche kommen derzeit rein geometrische Betrachtungen zum Einsatz. Diesbezüglich wird beispielhaft auf die WO 2013079581 A1 hingewiesen. Ausgangspunkt für das daraus bekannte Verfahren ist, dass Wärmestaus bzw. Hotspots in denjenigen Punkten bzw. Bereichen eines Bauteils angenommen werden, in denen die lokale Wärmeableitungsfähigkeit vermindert ist. Ferner wird davon ausgegangen, dass die lokale Wärmeableitungsfähigkeit umso höher ist, je größer das Verhältnis von "festem", d.h. zu konsolidierendem Material, zu nichtkonsolidiertem Material (Pulver) in der Umgebung eines bestimmten Punktes des zu generierenden Bauteils ist. In inneren Bereichen des Bauteils beträgt der Anteil des konsolidierten Materials 100%. Je näher zum Rand, desto höher ist der Anteil des nichtkonsolidierten Materials. Das bekannte Verfahren zur Berechnung des Verhältnisses, das mindestens in erster Näherung proportional zur lokalen Wärmeableitungsfähigkeit ist, umfasst die folgenden Schritte:

-　Zerteilung des Bauteils in kleine Zellen,

-　Definition des Materials in jeder Zelle (konsolidiertes oder nichtkonsolidiertes Material),

-　Definition von einem bestimmten Radius der Umgebung, in welcher die Anteile des konsolidierten und nichtkonsolidierten Materials bestimmt werden,

-　Definition der obengenannten Anteile für jede Zelle durch die Abfrage der benachbarten Zellen im Umgebungsradius.

Das bekannte Verfahren ermöglicht es, Randbereiche und damit mögliche thermisch kritische Bauteilbereiche, wie zum Beispiel Überhänge, automatisch zu erkennen. In solchen Bereichen wird der "normale" Wärmeabtransport in Richtung Bauplatte durch die Randeffekte beeinträchtigt. Diese Erkenntnis wird dann gemäß der vorgenannten Druckschrift verwendet, um in diesen thermisch kritischen Bauteilbereichen die Prozessparameter lokal anzupassen und damit den lokalen Wärmeeintrag und somit Wärmestaueffekte zu verringern.

Ein Nachteil der geometriebasierten Verfahren stellen die physikalisch nicht messbaren Basisgrößen dar. Das Verhältnis der Anteile des konsolidierten Materials zum nichtkonsolidierten Material (zum Beispiel Pulver) charakterisiert zwar indirekt die "lokale Wärmeableitungsfähigkeit" oder das "lokale Vermögen zum Wärmeabtransport", ist jedoch keine physikalische Größe, welche gemessen und als Basis für die Prozesssteuerung verwendet werden kann.

Bei den geometriebasierten Verfahren erfolgt die Ermittlung thermisch kritischer Bauteilbereiche unabhängig vom Material und Prozess. So können sich zum Beispiel gleiche thermisch kritische Bereiche bei Materialien mit unterschiedlicher Wärmeableitungsfähigkeit ergeben.

Zudem hängen die Ergebnisse der Ermittlung von thermisch kritischen Bauteilbereichen erheblich vom gewählten Umgebungsradius ab. Ein zu großer Wert des gewählten Umgebungsradius kann bei sehr filigranen Geometrien des Bauteils zu erheblichen Fehlern bei der Erkennung der thermisch kritischen Bereiche führen.

Der vorliegenden Erfindung liegt somit die Aufgabe zugrunde, ein Verfahren zur simulationsbasierten Erkennung thermisch kritischer Bauteilbereiche bei der additiven Herstellung eines dreidimensionalen Bauteils aus mehreren Bauteilschichten bereitzustellen, bei dem die Fähigkeit zur Wärmedissipation in jedem Punkt des Bauteils Berücksichtigung findet. Zu diesem Zweck wird ein physikalischer Begriff "Wärmeableitungsfähigkeit (Englisch: heat dissipation ability)" gezielt eingeführt, welcher die Fähigkeit eines bestimmten Punktes des Bauteils zur Wärmedissipation charakterisiert (genaue mathematische Definition des Begriffes "Wärmeableitungsfähigkeit" ist unten dargestellt). Die Werte und die Verteilung der Wärmeleitungsfähigkeit im Bauteil werden mittels einer numerischen Simulation berechnet. Die thermisch kritischen Bauteilbereiche lassen sich durch die niedrigen resultierenden Werte der Wärmeableitungsfähigkeit gut erkennen. Für die Bauteile gleicher Geometrie aus unterschiedlichen Materialien ergeben sich unterschiedliche Werte bzw. unterschiedliche Verteilung der Wärmeableitfähigkeiten.

Erfindungsgemäß wird diese Aufgabe gelöst durch ein Verfahren zur simulationsbasierten Erkennung thermisch kritischer Bauteilbereiche bei der additiven Herstellung eines dreidimensionalen Bauteils aus mehreren Bauteilschichten durch mehrfaches inkrementelles, insbesondere schichtweises, Hinzufügen von pulver-, draht- oder bandförmigem metallischem Bauteilausgangsmaterial und, insbesondere inkrementelles, formgebendes Verfestigen durch jeweiliges selektives Schmelzen und/oder Sintern des Bauteilausgangsmaterials mittels einer durch mindestens eine Energiequelle lokal eingebrachten Wärmemenge, umfassend

- simulationsbasierte Berechnung der Werte der lokalen Wärmeableitungsfähigkeit in Bauteilschichten des hergestellten Bauteils, und

- Erkennung von thermisch kritischen Bauteilbereichen anhand der simulationsbasiert berechneten Werte der lokalen Wärmeableitungsfähigkeiten oder anhand einer Funktion derselben.

Insbesondere handelt es sich um ein computer-implementiertes Verfahren.

Die lokale Wärmeableitungsfähigkeit charakterisiert die Fähigkeit eines Bauteilbereichs, Wärme in das Innere des Bauteils abzutransportieren.

Die numerische Berechnung kann sich über einen Zeitraum t erstrecken, der in der Größenordnung einer typischen Prozesszeit, z. B. der Zeit eines Belichtungsvektors, liegt.

Des Weiteren liefert die vorliegende Erfindung ein Verfahren zur bauteilspezifischen lokalen Anpassung, insbesondere Steuerung oder Regelung, einer lokalen Wärmegenerierung bei der additiven Herstellung eines dreidimensionalen Bauteils aus mehreren Bauteilschichten durch mehrfaches inkrementelles, insbesondere schichtweises, Hinzufügen von pulver-, draht- oder bandförmigem, insbesondere metallischem, Bauteilausgangsmaterial und, insbesondere inkrementelles, formgebendes Verfestigen durch jeweiliges selektives Schmelzen und/oder Sintern des Bauteilausgangsmaterials mittels einer durch mindestens eine Energiequelle lokal eingebrachten Wärmemenge, umfassend

- simulationsbasierte Erkennung thermisch kritischer Bauteilbereiche, insbesondere gemäß einem Verfahren nach einem der Ansprüche 1 bis 5,

- Bestimmung von Prozessparametern für die lokale Wärmegenerierung unter Vermeidung oder Reduzierung von lokalen Überhitzungen anhand der berechneten Werte der lokalen Wärmeableitungsfähigkeit in den erkannten thermisch kritischen Bauteilbereichen und

- additive Herstellung des Bauteils unter Verwendung der bestimmten Prozessparameter.

Insbesondere handelt es sich um ein computer-implementiertes Verfahren.

Bei dem Verfahren zur simulationsbasierten Erkennung kann vorgesehen sein, dass die lokale Wärmeableitungsfähigkeit als Divergenz eines Wärmeflusses oder als Funktion derselben, insbesondere als Zeitintegral der Divergenz des Wärmeflusses in einem bestimmten Zeitintervall, berechnet wird.

Alternativ kann vorgesehen sein, dass die lokale Wärmeableitungsfähigkeit als Divergenz des Produktes einer Wärmeleitfähigkeit des Bauteilausgangsmaterials und eines lokalen Temperaturgradienten, insbesondere als Zeitintegral der Divergenz besagten Produktes in einem bestimmten Zeitintervall, berechnet wird.

Wiederum alternativ kann vorgesehen sein, dass die lokale Wärmeableitungsfähigkeit anhand einer zeitlichen Ableitung der lokalen Temperatur oder anhand einer Funktion derselben, insbesondere als Zeitintegral des Produktes der zeitlichen Ableitung der lokalen Temperatur, der Wärmekapazität des Bauteilausgangsmaterials und der Dichte des Bauteilausgangsmaterials in einem bestimmten Zeitintervall, berechnet wird.

Weiterhin kann vorgesehen sein, dass die lokale Wärmeableitungsfähigkeit als Differenz zwischen einem Wärmeeintrag und dem Produkt der zeitlichen Ableitung der lokalen Temperatur, der Wärmekapazität des Bauteilausgangsmaterials und der Dichte des Bauteilausgangsmaterials oder als Funktion der Differenz, insbesondere als Zeitintegral dieser Differenz in einem bestimmten Zeitintervall, berechnet wird.

Insbesondere kann der Wärmeeintrag gleich Null gesetzt werden.

Ferner können die Wärmekapazität und Dichte des Bauteilausgangsmaterials als konstant angenommen werden.

Zur Ermittlung der lokalen Wärmeableitungsfähigkeiten kann eine thermische Simulation des Bauteilaufbauprozesses numerisch durchgeführt werden, bei der die Temperaturverteilung im ganzen Bauteil ohne thermische Aktivierung einzelner Bauteilschichten ausgehend von einer anfänglichen Temperaturverteilung berechnet wird.

Insbesondere kann dabei vorgesehen sein, dass hinsichtlich der anfänglichen Temperaturverteilung angenommen wird, dass die Temperatur in Aufbaurichtung steigt, oder die anfängliche Temperaturverteilung vereinfacht ein- oder zweidimensional berechnet wird oder die anfängliche Temperaturverteilung anhand von experimentellen Messungen ermittelt wird.

Ferner kann dabei insbesondere vorgesehen sein, dass, wenn hinsichtlich der anfänglichen Temperaturverteilung angenommen wird, dass die Temperatur in Aufbaurichtung steigt, anfängliche Temperaturgradienten quer zur Aufbaurichtung mit einem Wert von Null angenommen werden. Anstelle eines Wertes von genau Null kann in bestimmten Ausführungsformen auch einfach nur ein nahezu Null entsprechender Wert angenommen werden.

Gemäß einer weiteren besonderen Ausführungsform wird, wenn hinsichtlich der anfänglichen Temperaturverteilung angenommen wird, dass die Temperatur in Aufbaurichtung steigt, ein in Aufbaurichtung konstanter anfänglicher Temperaturgradient angenommen.

Insbesondere kann dabei vorgesehen sein, dass eine Randbedingung für die thermische Simulation so definiert ist, dass der Wärmefluss $q_{oben}$ an der Oberseite des Bauteils und der Wärmefluss $q_{unten}$ an der Unterseite des Bauteils gleichgroß sind und als ein negativer Wert des Produkts der Wärmeleitfähigkeit des Bauteilausgangsmaterials und des angenommenen konstanten Temperaturgradienten berechnet wird.

Alternativ kann eine Randbedingung für die thermische Simulation so definiert sein, dass eine vollständige thermische Isolation des gesamten Berechnungsgebiets vorliegt.

Vorteilhafterweise wird die thermische Simulation mit einer numerischen Methode, wie zum Beispiel der Methode der finiten Differenzen oder finiten Elemente, für die Lösung der partiellen Wärmeableitungsgleichung durchgeführt.

Gemäß einer weiteren besonderen Ausführungsform der vorliegenden Erfindung umfasst die Ermittlung von thermisch kritischen Bauteilbereichen einen Abgleich der simulationsbasiert ermittelten Werte der lokalen Wärmeableitungsfähigkeiten mit einem vorab festlegbaren Grenzwert für die lokale Wärmeableitungsfähigkeit, bei dessen Unterschreiten ein zugehöriges Volumenelement als ein thermisch kritischer Bauteilbereich deklariert wird.

Gemäß einer besonderen Ausführungsform des Verfahrens zur bauteilspezifischen lokalen Anpassung erfolgt die Bestimmung der Prozessparameter vor der additiven Herstellung.

Alternativ erfolgt die Bestimmung der Prozessparameter während der additiven Herstellung. Die Bestimmung der Prozessparameter kann aber auch vor der additiven Herstellung erfolgen und während der additiven Herstellung wiederholt werden.

Vorteilhafterweise umfassen die Prozessparameter die Leistung und/oder die Geschwindigkeit und/oder Fokuslage der mindestens einen Energiequelle.

Zweckmäßigerweise umfassen die Prozessparameter die Scan-Reihenfolge und/oder das Scan-Muster und/oder Zeit und/oder Zeitdauern des Eintrags von Wärmemengen.

Günstigerweise umfasst das Verfahren ferner eine Überwachung der Temperatur in einer jeweiligen obersten Bauteilschicht während der additiven Herstellung, insbesondere nach dem Auftragen einer jeweiligen Bauteilschicht.

Insbesondere kann dabei vorgesehen sein, dass das Verfahren eine Ermittlung eines oder beider zeitabhängigen/zeitabhängiger Temperaturgradienten quer zur Aufbaurichtung und/oder eines zeitabhängigen Temperaturgradienten in Aufbaurichtung und/oder einer zeitlichen Temperaturabhängigkeit und/oder eines Wärmeflusses von der Oberfläche dessen der Herstellung befindlichen Bauteils in sein Inneres umfasst.

Insbesondere kann dabei vorgesehen sein, dass das oder ein Verfahren zur bauteilspezifischen lokalen Anpassung, insbesondere Steuerung oder Regelung, einer lokal en Wärmegenerierung bei der additiven Herstellung eines dreidimensionalen Bauteils aus mehreren Bauteilschichten durch mehrfaches inkrementelles, insbesondere schichtweises, hinzufügen von pulver-, draht- oder bandförmigen, insbesondere metallischen, Bauteilausgangsmaterial und, insbesondere inkrementelles, formgebendes verfestigen durch jeweiliges selektives schmelzen und/oder sintern des Bauteilausgangsmaterials mittels einer durch mindestens einer Energiequelle lokal eingebrachten Wärmemenge, Definieren eines Schwellenwerts für lokale Wärmeableitungsfähigkeiten in Bauteilschichten des herzustellenden Bauteils, wenn ein Wärmeeintrag in einem erkannten thermisch kritischen Bauteilbereich bei der additiven Herstellung erfolgen soll, Überwachen, ob besagter Schwellenwert erreicht worden ist, und, wenn besagter Schwellenwert erreicht worden ist, Einbringen des Wärmeeintrags umfasst.

Alternativ kann aber auch vorgesehen sein ein Verfahren zur simulationsbasieren Erkennung thermisch kritischer Bauteilbereiche bei der additiven Herstellung eines dreidimensionalen Bauteils aus mehreren Bauteilschichten durch mehrfaches inkrementelles, insbesondere schichtweises, Hinzufügen von pulver-, draht-, oder bandförmigem, insbesondere metallischem, Bauteilausgangsmaterial und, insbesondere inkrementelles, formgebendes Verfestigen durch jeweiliges selektives Schmelzen und/oder Sintern des Bauteilausgangsmaterials mittels einer durch mindestens eine Energiequelle lokal eingebrachten Wärmemenge, umfassend Definieren eines Schwellenwerts für lokale Wärmeableitungsfähigkeiten in Bauteilschichten des herzustellenden Bauteils, wenn ein Wärmeeintrag in einem erkannten thermisch kritischen Bauteilbereich bei der additiven Herstellung erfolgen soll, Überwachen, ob besagter Schwellenwert erreicht worden ist, und, wenn besagter Schwellenwert erreicht worden ist, Einbringen des Wärrneeintrags. Mit anderen Worten umfasst das letztgenannte Verfahren keine (vorherige) simulationsbasierte Erkennung thermisch kritischer Bauteilbereiche.

Weiterhin kann bei den Verfahren vorgesehen sein, dass sie Berechnen eines angepassten Wärmeeintrags aufgrund der ermittelten Temperatur und/oder der ermittelten Temperaturgradienten und/oder des ermittelten Wärmeflusses für die erkannten thermisch kritischen Bauteilbereiche umfassen.

Insbesondere kann dabei vorgesehen sein, dass der angepasste Wärmeeintrag mittels einer inversen lokalen Berechnung mit einer Temperaturverteilung als Zielfunktion berechnet wird.

Schließlich liefert die vorliegende Erfindung auch ein oder mehrere computerlesbare (s) Medium/Medien, das/die durch Computer ausführbare Befehle umfasst/umfassen, die, wenn sie durch einen Computer ausgeführt werden, den Computer veranlassen, das Verfahren nach einem der vorangehenden Ansprüche durchzuführen.

Mittels des Verfahrens zur simulationsbasierten Erkennung thermisch kritischer Bauteilbereiche gemäß der vorliegenden Erfindung lassen sich thermisch kritische Bauteilbereiche aufgrund der Bestimmung der lokalen Wärmeableitungsfähigkeiten anhand von physikalischen messbaren Basisgrößen genauer ermitteln. Die berechnete Werte und Verteilung der Wärmeableitungsfähigkeit in einem Bauteil können wiederum für ein Verfahren zur bauteilspezifischen lokalen Anpassung, insbesondere Steuerung oder Regelung, einer lokalen Wärmegenerierung bei der additiven Herstellung eines dreidimensionalen Bauteils aus mehreren Bauteilschichten, verwendet werden, um Wärmestaus und Hotspots zu vermeiden, zumindest aber zu reduzieren.

Die vorliegende Erfindung liefert außerdem eine Vorrichtung zur Durchführung eines Verfahrens nach einem der Ansprüche 1 bis 10, umfassend ein Prozess- bzw. Bauraumgehäuse mit einer Bauplatte zur Abstützung eines herzustellenden Bauteils, eine Schichtenpräparierungseinrichtung zur Präparierung jeweiliger Bauteilschichten auf der Bauplatte, eine Bestrahlungseinrichtung zur Bestrahlung der jeweils zuletzt präparierten Bauteilschicht auf der Bauplatte nach Maßgabe von Geometriebeschreibungsdaten (Baujob) des herzustellenden Bauteils, eine Prozessoreinrichtung zur Durchführung von Berechnungen und eine Steuereinrichtung zur Steuerung der Vorrichtung, wobei die Steuereinrichtung dazu eingerichtet und programmiert ist, die Vorrichtung so zu steuern, dass ein Verfahren nach einem der Ansprüche 1 bis 10 durchgeführt wird.

In einer besonderen Ausführungsform der Vorrichtung weist diese auch eine Überwachungseinrichtung zur Überwachung einer Temperaturverteilung und/oder Temperaturänderung in der jeweils obersten Bauteilschicht auf.

Das Verfahren zur bauteilspezifischen lokalen Anpassung, insbesondere Steuerung oder Regelung, einer lokalen Wärmegenerierung bei der additiven Herstellung eines dreidimensionalen Bauteils aus mehreren Bauteilschichten kann zum Beispiel im Rahmen von Pre-processing verwendet werden.

Weitere Merkmale und Vorteile der Erfindung ergeben sich aus den beigefügten Ansprüchen und der nachfolgenden Beschreibung, in der mehrere Ausführungsbeispiele anhand der schematischen Zeichnungen im Einzelnen erläutert werden. Dabei zeigt:

Fig. 1 schematisch Beispiele für thermisch kritische Bauteilbereiche;

Fig. 2 eine schematische Darstellung zur Erläuterung der Definition der lokalen Wärmeableitungsfähigkeit;

Fig. 3    Anfangsbedingungen für ein Bauteil;

Fig. 4    eine anfängliche Verteilung von Isothermen in einem Bauteil

Fig. 5    Änderungen der Temperaturverteilung in einem Bauteil;

Fig. 6    eine berechnete Temperaturverteilung und berechnete Verteilung der Wärmeableitungsfähigkeit in einem Bauteil mit Öffnung zu einem Zeitpunkt $\tau$ und

Fig. 7    berechnete Verteilung der Wärmeableitungsfähigkeit in einem Bauteil mit einem Überhang.

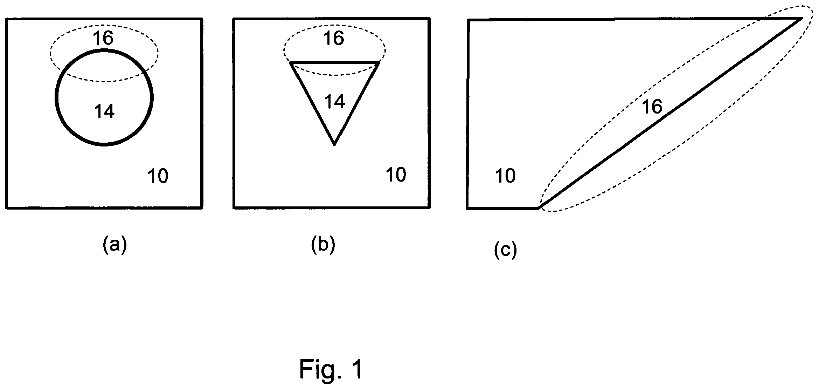

Figur 1 zeigt Beispiele für thermisch kritische Bauteilebereiche. Der Wärmetransport (nach unten) aus diesen Bauteilbereichen (Figuren 1a und 1b: Überhänge im Inneren eines Bauteils 10 mit einem gewünschten bzw. gezielt vorgesehen Kanal oder einer Öffnung 14; Figur 1c: Überhang in einer äußeren Fläche des Bauteils) wird durch die Nähe zum Bauteilrand 16 verhindert. Es ergeben sich lokale Wärmestaubereiche (die sogenannten "Hot Spots").

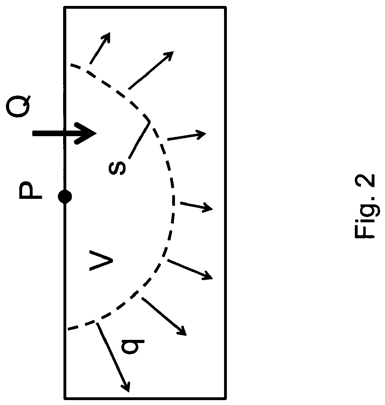

Zwecks Erkennung thermisch kritischer Bauteilbereiche wird bei der vorliegenden Erfindung der Begriff der Wärmeableitungsfähigkeit D ("Dissipation") der Bauteilschicht als Integral des Wärmeflusses $q$ [$W/m^2$] über die Oberfläche $s$ [$m^2$] auf folgende Weise definiert (s. Fig. 2):

$$D = \oint_S qnds = \int_V div(q)dV = \int_V div(-\lambda grad(T))dV \qquad (1)$$

$n$ ist der Normalvektor zur Oberfläche $s$; $V$ ist das betrachtete Volumen, $m^3$; $T$ ist die Temperatur, $K$; $\lambda$ ist die Wärmeleitfähigkeit, $W/(mK)$.

Die Wärmeableitungsfähigkeit kann aufgrund der Wärmeleitungsgleichung auch in einer folgenden Form dargestellt werden:

$$D = \int_V div(q)dV = \int_V \left(Q - c\rho\frac{\partial T}{\partial t}\right)dV \qquad (2)$$

$Q$ ist die Leistung der Wärmequelle im Volumen $V$, [$W/m^3$]; c ist die spezifische Wärmekapazität, [$J/(kgK)$]; p ist die Dichte, [$kg/m^3$]; $t$ ist die Zeit, [$s$].

In einem bestimmten Punkt P des Bauteils (V→0) wird dann die lokale Wärmeableitungsfähigkeit $D^{loc}$ wie folgt definiert:

$$D^{loc} = div(q) = Q - c\rho\frac{\partial T}{\partial t} \qquad (3)$$

Die lokale Wärmeableitungsfähigkeit hängt nicht nur von den Werkstoffeigenschaften (Wärmeleitung, Wärmekapazität, Dichte) und vom Wärmeeintrag ab. Sie wird auch von den Randbedingungen, wie z. B. die lokale Bauteilgeometrie, stark beeinflusst.

Für die Zeiten einer reinen Abkühlung eines Punktes der Bauteilschicht, d.h. für die Zeiten, in denen die Wärmequelle in dem betrachteten Punkt nicht mehr wirkt (Leistung der Wärmequelle $Q = 0$) ergibt sich eine noch einfachere Form der Darstellung:

$$D^{loc} = -c\rho\frac{\partial T}{\partial t} \qquad (4)$$

Diese Darstellung der lokalen Wärmeableitungsfähigkeit ermöglicht eine Berechnung der Fähigkeit eines bestimmten Punktes des Bauteils zur Dissipation der Wärme aufgrund der experimentellen Beobachtungen der Abkühlgeschwindigkeiten (zeitliche Ableitung der Temperatur).

Generell ändert sich die Temperaturverteilung im Bauteil und dementsprechend die lokale Wärmeableitungsfähigkeit mit der Zeit. Daher ist es sinnvoll, die lokale Wärmeableitungsfähigkeit über eine bestimmte Zeit zu integrieren und den resultierenden Wert für die Charakterisierung der Wärmedissipation in einem bestimmten Punkt zu verwenden.

Unter Annahme der Abwesenheit einer Wärmequelle, d.h. Wärmeeintrag = Null, ergibt sich ein folgender Wert:

$$D_{int}^{loc} = -\int_{t_1}^{t_2} c\rho \frac{\partial T}{\partial t} dt = -\int_{t_1}^{t_2} \frac{\partial H}{\partial t} dt = -\Delta H \qquad (5)$$

$\Delta H$ ist die Änderung der Enthalpie, $J$, im Zeitintervall vom $t_1$ bis $t_2$.

Unter Annahme der temperaturunabhängigen Materialeigenschaften kann die lokale Wärmeableitungsfähigkeit durch die Änderung der Temperatur in der Zeit charakterisiert werden:

$$D_{int}^{loc} = -\Delta H = -c\rho\Delta T \qquad (6)$$

Es ist anzumerken, dass nicht die Temperatur selbst, sondern die zeitliche Änderung der Temperatur die Fähigkeit zur Wärmedissipation charakterisieren kann. Eine reine Bestimmung der Temperatur und/oder deren Verteilung ist für die Quantifizierung der Wärmeableitungsfähigkeit nicht ausreichend.

Die letzten zwei Formulierungen (Formeln 5 und 6) werden in der vorliegenden Erfindung auch als "lokale Wärmeableitungsfähigkeit" bezeichnet.

Als ein nützlicher Wert zur Charakterisierung der lokalen Wärmeableitungsfähigkeit hat sich eine relative lokale Wärmeableitungsfähigkeit gezeigt, welche eine Relation zwischen $D_{int}^{loc}$ zum anfänglichen Temperaturgradienten darstellt:

$$D_{rel}^{loc} = \frac{D_{int}^{loc}}{\dfrac{\partial T(x,y,z,0)}{\partial z}}$$

Anhand einer der oben beschriebenen Darstellungen der lokalen Wärmeableitungsfähigkeit (als lokale Abkühlgeschwindigkeit, zeitliche Enthalpie- oder Temperaturänderung) kann die lokale Wärmeableitungsfähigkeit im Rahmen einer simulationsbasierten Lösung einer Wärmeleitungsgleichung in einem Bauteil berechnet werden.

Indirekte physikalische Interpretation des Wertes der lokalen Wärmeableitungsfähigkeit: Die Wärme in einem additiven Herstellungsverfahren wird normalerweise hauptsächlich nach unten, von einer generierten Bauteilschicht in das Innere des Bauteils transportiert. Dabei deutet der Wert einer lokalen Wärmeableitungsfähigkeit indirekt auf die Menge der unter den dem bestimmten Punkt der Bauteilschicht befindlichen Masse des "kalten" konsolidierten Materials. Je mehr "kalte" Materialmasse sich unter einem bestimmten Punkt einer Bauteilschicht befindet, desto höher ist der Wert einer lokalen Wärmeableitungsfähigkeit.

Für eine direkte thermische Berechnung des Aufbauprozesses wäre eine sequentielle thermische Aktivierung aller Bauteilschichten/Segmente notwendig. Eine derartige Prozedur würde entsprechend zahlreiche Zeitschritte fordern und wäre mit einem hohen Berechnungsaufwand verbunden.

Gemäß einer besonderen Ausführungsform der vorliegenden Erfindung kann durch eine vereinfachte Ausführung der numerischen Simulation die Ermittlung der lokalen Wärmeableitungsfähigkeiten wesentlich schneller erfolgen. Dabei wird das ganze Bauteil ohne thermische Aktivierung einzelner Bauteilschichten/Segmente berechnet. Eine solche vereinfachte Simulation wird zur drastischen Reduzierung der erforderlichen Rechenzeiten führen (je größer das Bauteil ist, desto größer wird die Ersparnis der Rechenzeit).

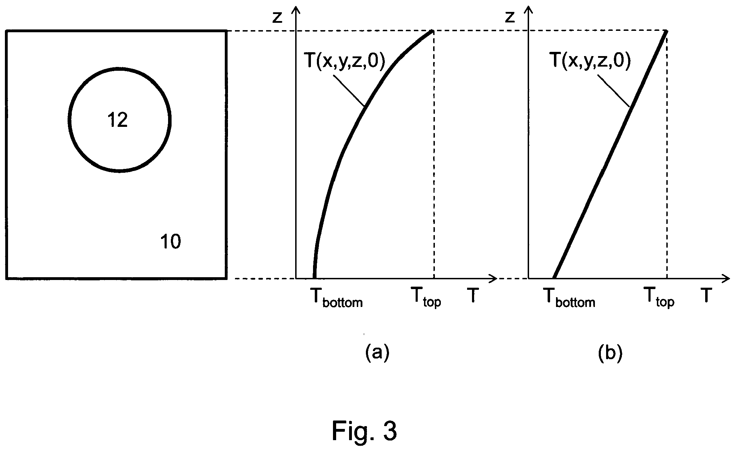

Als Anfangsbedingung wird in dieser oder einer anderen Ausführungsform eine "künstliche" Temperaturverteilung mit in Aufbaurichtung (z-Richtung) aufsteigender Temperatur verwendet. Die anfänglichen Temperaturgradienten T in x- und y-Richtung werden als Null eingesetzt (siehe Figur 3a; links daneben Bauteil 10 mit einem Kanal 12):

$$\begin{cases} \dfrac{\partial T(x,y,z,0)}{\partial z} > 0 \\[2mm] \dfrac{\partial T(x,y,z+\Delta z,0)}{\partial z} \geq \dfrac{\partial T(x,y,z,0)}{\partial z} \\[2mm] \dfrac{\partial T(x,y,z,0)}{\partial x} = \dfrac{\partial T(x,y,z,0)}{\partial y} = 0 \end{cases}$$

Eine solche Temperaturverteilung als Anfangsbedingung imitiert die Temperaturverteilung im realen Aufbauprozess. Für jede Bauteilschicht gewährleistet diese Verteilung, dass der Wärmefluss am Anfang der Berechnung ausschließlich nach unten erfolgt.

Eine besonders effektive Variante der oben genannten Anfangsbedingung repräsentiert einen konstanten Temperaturgradienten in Aufbaurichtung (siehe Figur 3b):

$$\begin{cases} \dfrac{\partial T(x,y,z,0)}{\partial z} = const > 0 \\[4mm] \dfrac{\partial T(x,y,z,0)}{\partial x} = \dfrac{\partial T(x,y,z,0)}{\partial y} = 0 \end{cases}$$

Der konstante anfängliche Temperaturgradient in Aufbaurichtung, vordefiniert für jeden Punkt des Bauteils und damit auch für jede Bauteilschicht, weist den gleichen Nullwert der lokalen Wärmeableitungsfähigkeit auf:

$$D^{loc}(x,y,z,0) = div\big(q(x,y,z,0)\big) = div\big(-\lambda\, grad(T(x,y,z,0))\big) =$$

$$= div\left(-\lambda\left(\frac{\partial T(x,y,z,0)}{\partial x} + \frac{\partial T(x,y,z,0)}{\partial y} + \frac{\partial T(x,y,z,0)}{\partial z}\right)\right) =$$

$$= div\big(-\lambda(\,0 + 0 + const)\big) = 0$$

Der Nullwert der lokalen Wärmeableitungsfähigkeit für jeden Punkt des Bauteils stellt eine bequeme Ausgangsbasis dar, um die nachfolgenden Änderungen der lokalen Wärmeableitungsfähigkeit in jedem Bauteilpunkt darzustellen.

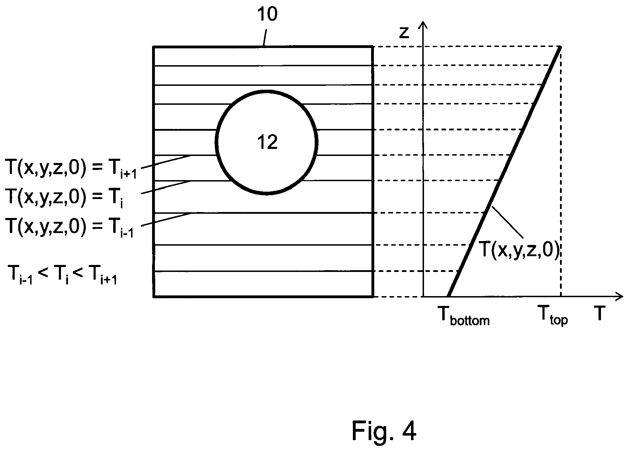

Die oben beschriebenen Anfangsbedingungen führen zu einer flachen Form der Isolinien des Temperaturfeldes (siehe Figur 4 links). Figur 4 zeigt die anfängliche Verteilung der Isothermen in einem Bauteil 10 mit einem Kanal 12. Ein Nullwert des Temperaturgradienten quer zur Aufbaurichtung führt zur Ausbildung von flachen Isolinien ($T_{i-1}$, $T_i$, $T_{i+1}$ ...) des Temperaturfeldes.

Im allgemeinen wird - wie vorangehend anhand eines Ausführungsbeispiels beschrieben - die anfängliche Temperaturverteilung einfach angenommen. Für eine genauere Bestimmung der anfänglichen Temperaturverteilung können sowohl vereinfachte Lösungen, wie zum Beispiel eine schnelle 1- oder 2-dimensionale Berechnung des Temperaturfeldes beim Aufbauprozess als auch experimentelle Messungen verwendet werden.

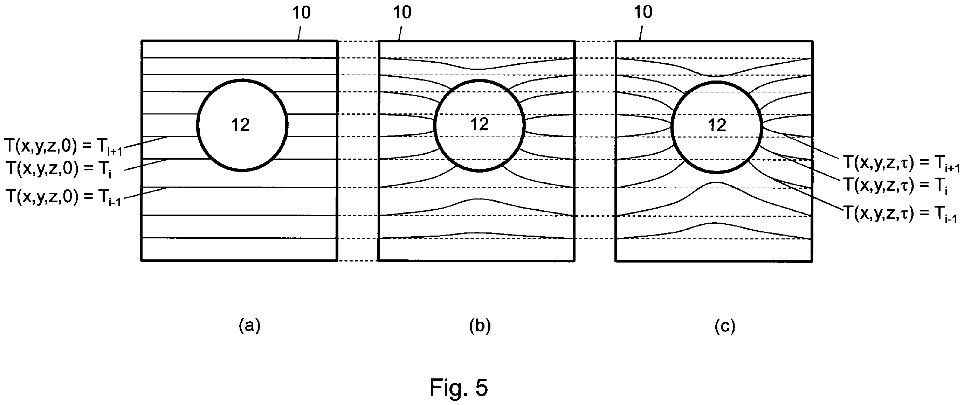

Während der Berechnung "offenbaren" sich die Wärmestaubereiche durch eine Umverteilung der Temperatur in dem gesamten Bauteil. Die Wärmestaubereiche, das heißt alle kritischen Bauteilbereiche, lassen sich dann zum Beispiel durch die Verringerung des Wertes $D_{int}^{loc}$ erkennen (siehe Figur 5). Figur 5 zeigt die Änderung der Temperaturverteilung zum bzw. nach einer Zeit $\tau$ (Fig. 5c) und die anfängliche Temperaturverteilung (Fig. 5a) sowie eine zwischenzeitliche Temperaturverteilung (Fig. 5b). Es ergibt sich eine neue Verteilung der Isothermen. Im oberen Bereich des Bauteils 10 bildet sich offenbar ein Wärmestau ($D_{int}^{loc}<0$).

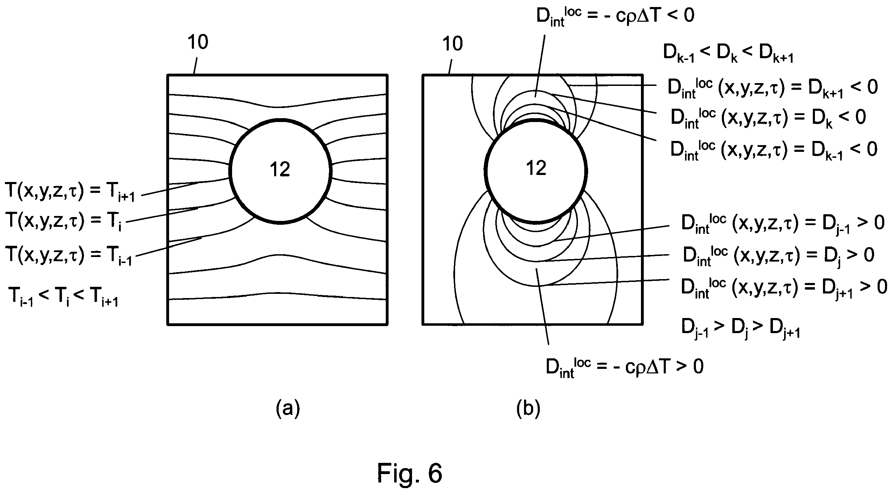

Fig. 6 zeigt noch einmal die Temperaturverteilung von Fig. 5c) und die zugehörige Verteilung der zeitlich integralen lokalen Wärmeableitungsfähigkeit zum Zeitpunkt $\tau$. Als Zeitpunkt $\tau$ kann ein vordefinierter Zeitpunkt größer als 0 ausgewählt werden. Dabei ist es sinnvoll, dessen Größe anhand der charakteristischen Prozesszeiten, z.B. anhand der typischen Abkühlzeiten einer Schicht auszuwählen. Im thermisch kritischen Bereich des Bauteils 10 bildet sich ein Wärmestau, erkennbar durch die niedrige Werte der lokalen Wärmeableitungsfähigkeit ($D_{int}^{loc}<0$). Im Bauteil 10, im unteren Bereich einer Öffnung 12 (Fig. 6b) bildet sich ein "Gegenbereich" mit einem hohen Wärmedissipationsvermögen aus ($D_{int}^{loc}<0$).

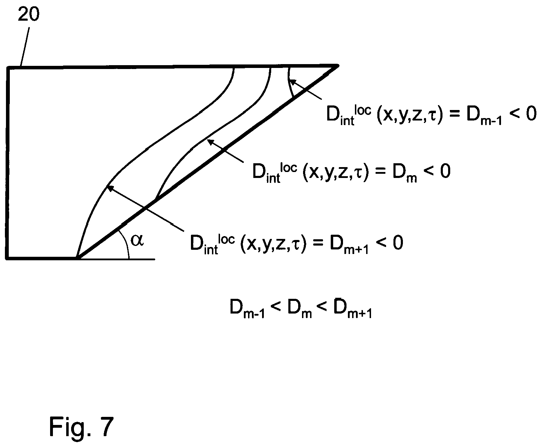

Fig. 7 zeigt die Verteilung der Wärmeableitungsfähigkeit in einem Bauteil 20 mit einem Überhang mit Winkel $\alpha$ zur Bodenplatte. Bei kleineren Winkeln $\alpha$ ergeben sich andere Verteilungen und niedrigere Werte der lokalen Wärmeableitungsfähigkeit.

Gemäß einer besonderen Ausführungsform des Verfahrens zur bauteilspezifischen lokalen Anpassung einer lokalen Wärmegenerierung bei der additiven Herstellung eines dreidimensionalen Bauteils aus mehreren Bauteilschichten können aufgrund der Informationen über die lokale Wärmeableitungsfähigkeit, beispielsweise gemäß den obigen Ausführungen, die Prozessparameter sowohl noch vor dem eigentlichen Aufbauprozess als auch während des Aufbauprozesses angepasst werden. Zu diesen Prozessparametern können die wärmeeintragsrelevanten Größen, wie Leistung, Geschwindigkeit und Fokuslage der Energie- bzw. Wärmequelle(n) sowie die Reihenfolgen und/oder die Zeitpunkte der Erzeugung einzelner Wärmeeinträge gehören. Das Optimierungsziel ist der Temperaturausgleich in den thermisch kritischen Bauteilbereichen (wärmestaukritischen Bauteilbereichen), um Überhitzungen und Sintereffekte in diesen Bauteilbereichen zu vermeiden.

Als eine sehr sinnvolle Maßnahme erscheint vor allem eine Erhöhung der Pausen zwischen der Erzeugung einzelner Wärmeeinträge (zum Beispiel Belichtungsvektoren beim Laserschmelzen) in den Gebieten mit einer sinkenden Wärmeableitungsfähigkeit. Dadurch wird eine bessere Dissipation der Wärme ermöglicht.

Eine bessere Dissipation der Wärme wird auch dadurch erreicht, dass der Wärmeeintrag zunächst in den Bereichen einer Bauteilschicht mit einer höheren lokalen Wärmeableitungsfähigkeit und dann in den Bereichen mit einer niedrigeren Wärmeableitungsfähigkeit erfolgt.

Es kann auch sinnvoll sein, in den Bauteilbereichen mit einer sinkenden Wärmeableitungsfähigkeit die Leistung der Energie- bzw. Wärmequelle(n) (zum Beispiel eines Lasers) zu reduzieren und/oder die Geschwindigkeit der Energie- bzw. Wärmequelle(n) zu erhöhen. Dadurch wird in diesen wärmestaukritischen Bereichen der gesamte Wärmeeintrag verringert.

Es kann auch ein Überwachungssystem entwickelt werden. Das Überwachungssystem kann zum Beispiel die Werte der Temperatur zu einem oder zu bestimmten Zeitpunkten auf der aufgebauten Bauteilschicht als Messergebnis liefern. Dies kann zum Beispiel durch optische Messungen problemlos realisiert werden. Dadurch können in jedem Punkt einer Bauteilschicht die aktuelle Temperatur T(x, y, z, t) und/oder der Temperaturgradient in x- und y-Richtung

$\frac{\delta T(x,y,z,t)}{\delta x}$ und $\frac{\delta T(x,y,z,t)}{\delta y}$ und/oder die Abkühl- oder Aufheizgeschwindigkeit $\left(\frac{\delta T}{\delta t}\right)$ ermittelt werden.

Zum Beispiel während Pausen zwischen Wärmeeinträgen oder bei Messung in Bereichen, die sich weit weg von dem laufenden Wärmeeintrag befinden, kann aufgrund dieser Daten auch der Temperaturgradient in z-Richtung

$\frac{\delta T(x,y,z,t)}{\delta z}$ aus der Wärmeleitungsgleichung ermittelt werden:

$$div\left(-\lambda\left(\frac{\partial T(x,y,z,t)}{\partial x} + \frac{\partial T(x,y,z,t)}{\partial y} + \frac{\partial T(x,y,z,t)}{\partial z}\right)\right) = c\rho\frac{\partial T}{\partial t}$$

Damit wird auch der Wärmefluss von der Oberfläche in das Innere des Bauteils definierbar:

$$q_z = -\lambda\frac{\partial T(x,y,z,t)}{\partial z}$$

Geregelte Prozessführung: Eine relativ einfache Variante der Prozessführung aufgrund der oben beschriebenen Messdaten stellt eine geregelte Prozessführung dar. Bei der geregelten Prozessführung wird zunächst ein bestimmter Schwellenwert der lokalen Wärmeableitungsfähigkeit definiert. Auf Basis einer Vorberechnung werden thermisch kritische Bauteilbereiche dem Überwachungssystem im Vorfeld bekannt. Durch gezielte Betrachtung dieser Bereiche, zum Beispiel mit einer höheren optischen Auflösung, werden kritische Stellen präzise überwacht. Sobald ein Wärmeeintrag in einem thermisch kritischen Bauteilbereich erfolgen soll, wird dann das Überwachungssystem prüfen, ob der Schwellenwert der lokalen Wärmeableitungsfähigkeit am Ort des nächstgeplanten Wärmeeintrags erreicht worden ist. Bei einer positiven Meldung wird das Überwachungssystem ein "grünes Licht" zur Erzeugung von diesem neuen Wärmeeintrag geben. Dieser Prozess wiederholt sich für weitere Wärmeeinträge im kritischen Bereich.

Als ein Schwellenwert für einen einzubringenden Wärmeeintrag kann zum Beispiel der Wert von $D_{int}^{loc}$ verwendet werden, welcher gleich der aufzubringenden Energiemengen ist.

Bei der "geregelten" Prozessführung wird der Wärmeeintrag nicht berechnet. Die nächste "Portion" der Wärme wird eingeführt, sobald das Messsystem das Signal gibt, dass eine äquivalente Portion der Wärme an dem Ort des Wärmeeintrags in das Bauteilinnere "gesunken" ist.

Gesteuerte Prozessführung: Eine relativ komplexere Variante der Prozessführung aufgrund der oben beschriebenen Messdaten stellt eine gesteuerte Prozessführung dar. Bei dieser Variante werden auf Basis der Messungen die Randbedingungen in dem thermisch kritischen Bauteilbereich für eine lokale Berechnung ermittelt (Temperatur und/oder Temperaturgradient und/oder Wärmefluss).

In einem nächsten Schritt wird eine inverse lokale Berechnung durchgeführt. Aufgrund der lokalen Berechnung werden die aktuellen Prozessparameter angepasst.

Alternativ kann aufgrund zahlreicher inverser Vorberechnungen für unterschiedliche mögliche Randbedingungen eine Datenbank im Vorfeld aufgebaut werden, so dass es möglich wird, die Prozessparameteranpassung auf Basis der gemessenen Randbedingungen direkt durchzuführen. Dies ist eine praktikablere Variante der gesteuerten Prozessführung.

Bei der "gesteuerten" Prozessführung wird der Wärmeeintrag berechnet. Um den Zeitpunkt und die Größe für die nächste "Portion" der Wärme zu ermitteln, wird aufgrund der Messungen eine schnelle inverse numerische Berechnung durchgeführt.

Eine praktische Alternative: Aufgrund zahlreicher inverser Vorberechnungen werden fast alle möglichen Situationen in einer Datenbank gespeichert. Dann wird der Wärmeeintrag aus einer Datenbank für die bestimmten Messergebnisse einfach "genommen".

Automatisierte Erkennung von Defekten: Typische Defekte bei der additiven Herstellung, wie unerwünschte Hohlräume, wie zum Beispiel Poren oder Lufteinschlüsse, die erwartungsgemäß in überhitzten Bauteilbereichen verstärkt auftreten, stellen insbesondere in thermisch kritischen Bauteilbereichen ein Hindernis zum Wärmefluss dar und führen zu einem lokalen Wärmestau. Daher kann die Erkennung der Defekte aufgrund der Änderung der Wärmeableitungsfähigkeit mit einem Überwachungssystem vorgenommen werden.

Die in der vorstehenden Beschreibung, in den Zeichnungen sowie in den Ansprüchen offenbarten Merkmale der Erfindung können sowohl einzeln als auch in den beliebigen Kombinationen für die Verwirklichung der Erfindung in ihren verschiedenen Ausführungsformen wesentlich sein.

**Bezugszeichenliste:**

10    Bauteil
12    Kanal
14    Öffnung
16    Bauteilrand
20    Bauteil

**Patentansprüche**

1. Verfahren zur simulationsbasierten Erkennung thermisch kritischer Bauteilbereiche bei der additiven Herstellung eines dreidimensionalen Bauteils (10) aus mehreren Bauteilschichten durch mehrfaches inkrementelles, insbesondere schichtweises, Hinzufügen von pulver-, draht- oder bandförmigem, insbesondere metallischem, Bauteilausgangsmaterial und, insbesondere inkrementelles, formgebendes Verfestigen durch jeweiliges selektives Schmelzen und/oder Sintern des Bauteilausgangsmaterials mittels einer durch mindestens eine Energiequelle lokal eingebrachten Wärmemenge, umfassend

   - simulationsbasierte Berechnung der Werte der lokalen Wärmeableitungsfähigkeit in Bauteilschichten des hergestellten Bauteils (10), und
   - Erkennung von thermisch kritischen Bauteilbereichen anhand der simulationsbasiert berechneten Werte der lokalen Wärmeableitungsfähigkeiten oder anhand einer Funktion derselben.

2. Verfahren nach Anspruch 1, wobei die lokale Wärmeableitungsfähigkeit anhand einer zeitlichen Ableitung der lokalen Temperatur oder anhand einer Funktion derselben, insbesondere als Zeitintegral des Produktes der zeitlichen Ableitung der lokalen Temperatur, der Wärmekapazität des Bauteilausgangsmaterials und der Dichte des Bauteilausgangsmaterials in einem bestimmten Zeitintervall, berechnet wird.

3. Verfahren nach einem der vorangehenden Ansprüche, wobei bei der simulationsbasierten Berechnung der Wärmeableitungsfähigkeit hinsichtlich der anfänglichen Temperaturverteilung angenommen wird, dass die Temperatur in Aufbaurichtung steigt.

4. Verfahren nach Anspruch 3, wobei, anfängliche Temperaturgradienten quer zur Aufbaurichtung einen Wert von Null aufweisen.

5. Verfahren nach einem der vorangehenden Ansprüche, wobei die Ermittlung von thermisch kritischen Bauteilbereichen einen Abgleich der simulationsbasiert berechneten Werte der lokalen Wärmeableitungsfähigkeiten mit einem vorab festlegbaren Grenzwert für die lokale Wärmeableitungsfähigkeit, bei dessen Unterschreiten ein zugehöriges Volumenelement als ein thermisch kritischer Bauteilbereich deklariert wird, umfasst.

6. Verfahren zur bauteilspezifischen lokalen Anpassung, insbesondere Steuerung oder Regelung, einer lokalen Wärmegenerierung bei der additiven Herstellung eines dreidimensionalen Bauteils (10) aus mehreren Bauteilschichten durch mehrfaches inkrementelles, insbesondere schichtweises, Hinzufügen von pulver-, draht- oder bandförmigem, insbesondere metallischem, Bauteilausgangsmaterial und, insbesondere inkrementelles, formgebendes Verfestigen durch jeweiliges selektives Schmelzen und/oder Sintern des Bauteilausgangsmaterials mittels einer durch mindestens eine Energiequelle lokal eingebrachten Wärmemenge, umfassend

- simulationsbasierte Erkennung thermisch kritischer Bauteilbereiche gemäß einem Verfahren nach einem der Ansprüche 1 bis 5,
- Bestimmung von Prozessparametern für die lokale Wärmegenerierung unter Vermeidung oder Reduzierung von lokalen Überhitzungen anhand der berechneten Werte der lokalen Wärmeableitungsfähigkeit in den erkannten thermisch kritischen Bauteilbereichen und
- additive Herstellung des Bauteils (10) unter Verwendung der bestimmten Prozessparameter.

7. Verfahren nach Anspruch 6, wobei die Prozessparameter die Leistung und/oder die Geschwindigkeit und/oder Fokuslage der mindestens einen Energiequelle umfassen.

8. Verfahren nach einem der Ansprüche 6 oder 7, wobei die Prozessparameter die Scan-Reihenfolge und/oder das Scan-Muster und/oder Zeitpunkt und/oder Zeitdauern des Eintrags von Wärmemengen umfassen.

9. Verfahren nach einem der Ansprüche 6 bis 8, ferner umfassend eine Überwachung der zeitlichen Temperaturänderungen in einer jeweiligen obersten Bauteilschicht während der additiven Herstellung, insbesondere nach dem Auftragen einer jeweiligen Bauteilschicht.

10. Verfahren zur bauteilspezifischen lokalen Anpassung, insbesondere Steuerung oder Regelung, einer lokalen Wärmegenerierung bei der additiven Herstellung eines dreidimensionalen Bauteils (10) aus mehreren Bauteilschichten durch mehrfaches inkrementelles, insbesondere schichtweises, Hinzufügen von pulver-, draht- oder bandförmigem, insbesondere metallischem, Bauteilausgangsmaterial und, insbesondere inkrementelles, formgebendes Verfestigen durch jeweiliges selektives Schmelzen und/oder Sintern des Bauteilausgangsmaterials mittels einer durch mindestens eine Energiequelle lokal eingebrachten Wärmemenge, umfassend

- definieren eines Schwellenwerts für lokale Wärmeableitungsfähigkeiten in Bauteilschichten des herzustellenden Bauteils (10),
- wenn ein Wärmeeintrag in einem erkannten thermisch kritischen Bauteilbereich bei der additiven Herstellung erfolgen soll, Überwachen, ob besagter Schwellenwert erreicht worden ist, und,
- wenn besagter Schwellenwert erreicht worden ist, Einbringen des Wärmeeintrags.

Fig. 1

Fig. 2

Fig. 3

Fig. 4

EP 3 318 352 A1

$T(x,y,z,0) = T_{i+1}$
$T(x,y,z,0) = T_i$
$T(x,y,z,0) = T_{i-1}$

$T(x,y,z,\tau) = T_{i+1}$
$T(x,y,z,\tau) = T_i$
$T(x,y,z,\tau) = T_{i-1}$

(a)

(b)

(c)

Fig. 5

EP 3 318 352 A1

Fig. 6

20

$$D_{int}^{loc}(x,y,z,\tau) = D_{m-1} < 0$$

$$D_{int}^{loc}(x,y,z,\tau) = D_m < 0$$

$\alpha$

$$D_{int}^{loc}(x,y,z,\tau) = D_{m+1} < 0$$

$$D_{m-1} < D_m < D_{m+1}$$

Fig. 7

Europäisches
Patentamt

European
Patent Office

Office européen
des brevets

**EUROPÄISCHER RECHERCHENBERICHT**

Nummer der Anmeldung

EP 17 00 1797

| | **EINSCHLÄGIGE DOKUMENTE** | | |
|---|---|---|---|
| Kategorie | Kennzeichnung des Dokuments mit Angabe, soweit erforderlich, der maßgeblichen Teile | Betrifft Anspruch | KLASSIFIKATION DER ANMELDUNG (IPC) |
| X<br><br>A | US 2016/059352 A1 (SPARKS TODD EUGENE [US]) 3. März 2016 (2016-03-03)<br>* Absätze [0006] - [0010] *<br>* Absätze [0011], [0017] - [0019], [0031]; Abbildungen 1,3-8 *<br>* Absätze [0032] - [0125], [0138] - [0141]; Ansprüche 1-6 *<br>----- | 6-10<br><br>1-5 | INV.<br>B22F3/105<br>B33Y10/00<br>B33Y50/02<br>B29C64/00<br>B29C64/386<br>G01N29/44<br>G05B19/418<br>G06F17/50<br>G06T17/20<br><br>ADD.<br>G01N11/00 |
| X | US 2016/059493 A1 (SPARKS TODD EUGENE [US] ET AL) 3. März 2016 (2016-03-03)<br>* Absätze [00001] - [0012], [0029], [0032], [0034]; Abbildungen 3-4,6-7 *<br>* Absätze [0045] - [0130], [0132], [0135] - [0151]; Ansprüche 1-4; Abbildungen 8-12 *<br>----- | 6-10 | |
| X<br><br>A | US 2015/352794 A1 (NGUYEN VU THUA [AU] ET AL) 10. Dezember 2015 (2015-12-10)<br>* Absätze [0001] - [0005], [0007] - [0034], [0092] - [0108]; Abbildungen 3-4,7-11,25-32 *<br>* Absätze [0110] - [0117], [0123], [0128], [0134]; Ansprüche 1-43 *<br>-----<br>-/-- | 6-10<br><br>1-5 | |
| | | | **RECHERCHIERTE SACHGEBIETE (IPC)**<br><br>B22F<br>B33Y<br>B29C<br>B23K<br>B28B<br>A61C<br>G01N<br>G05B<br>G06F<br>G06T |

Der vorliegende Recherchenbericht wurde für alle Patentansprüche erstellt

| Recherchenort | Abschlußdatum der Recherche | Prüfer |
|---|---|---|
| Den Haag | 26. März 2018 | Aliouane, Nadir |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
........................................................................
& : Mitglied der gleichen Patentfamilie, übereinstimmendes
    Dokument

EPO FORM 1503 03.82 (P04C03)

Europäisches
Patentamt

European
Patent Office

Office européen
des brevets

# EUROPÄISCHER RECHERCHENBERICHT

Nummer der Anmeldung

EP 17 00 1797

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | KUNDAKCIOGLU ERDEM ET AL: "Transient thermal modeling of laser-based additive manufacturing for 3D freeform structures", THE INTERNATIONAL JOURNAL OF ADVANCED MANUFACTURING TECHNOLOGY, SPRINGER, LONDON, Bd. 85, Nr. 1, 17. Oktober 2015 (2015-10-17), Seiten 493-501, XP035987357, ISSN: 0268-3768, DOI: 10.1007/S00170-015-7932-2 [gefunden am 2015-10-17] | 6,7,10 | |
| A | * Zusammenfassung; Abbildungen 2,4 * <br> * Seite 494 - Seite 498 * <br> * Seite 499 - Seite 501 * <br> ----- | 1-3 | |
| X | AHMED HUSSEIN ET AL: "Finite element simulation of the temperature and stress fields in single layers built without-support in selective laser melting", MATERIALS AND DESIGN, Bd. 52, 1. Dezember 2013 (2013-12-01), Seiten 638-647, XP055287179, GB ISSN: 0261-3069, DOI: 10.1016/j.matdes.2013.05.070 * Zusammenfassung; Abbildungen 1-3,6 * <br> * Seite 639 - Seite 641 * <br> * Seite 638, Spalte 2, Absatz 2 - Seite 639, Spalte 1, Absatz 1 * <br> * Seite 641, Spalte 2, Absatz 1; Abbildung 4 * <br> * Seite 644 * <br> ----- <br> -/-- | 6-10 | RECHERCHIERTE SACHGEBIETE (IPC) |

Der vorliegende Recherchenbericht wurde für alle Patentansprüche erstellt

| Recherchenort | Abschlußdatum der Recherche | Prüfer |
|---|---|---|
| Den Haag | 26. März 2018 | Aliouane, Nadir |

EPO FORM 1503 03.82 (P04C03)

Seite 2 von 3

Europäisches
Patentamt

European
Patent Office

Office européen
des brevets

# EUROPÄISCHER RECHERCHENBERICHT

**Nummer der Anmeldung**

EP 17 00 1797

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | US 2014/332507 A1 (FOCKELE MATTHIAS [DE]) 13. November 2014 (2014-11-13) * Absätze [0014], [0016] - [0018], [0019], [0021], [0026], [0029]; Abbildungen 1-3,7 * * Absätze [0044] - [0045], [0048] - [0066] * ----- | 1-10 | |
| A | CN 104 190 930 A (CHONGQING INST GREEN & INTELLIGENT TECHNOLOGY CAS) 10. Dezember 2014 (2014-12-10) * das ganze Dokument * ----- | 1-10 | |
| A | US 6 813 533 B1 (SEMAK VLADIMIR V [US]) 2. November 2004 (2004-11-02) * Zusammenfassung * * Spalte 2 - Spalte 5; Ansprüche 1-2 * ----- | 1-10 | |

**RECHERCHIERTE SACHGEBIETE (IPC)**

Der vorliegende Recherchenbericht wurde für alle Patentansprüche erstellt

| Recherchenort | Abschlußdatum der Recherche | Prüfer |
|---|---|---|
| Den Haag | 26. März 2018 | Aliouane, Nadir |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
...........................................................................
& : Mitglied der gleichen Patentfamilie, übereinstimmendes
    Dokument

EPO FORM 1503 03.82 (P04C03)

Seite 3 von 3

**ANHANG ZUM EUROPÄISCHEN RECHERCHENBERICHT**
**ÜBER DIE EUROPÄISCHE PATENTANMELDUNG NR.**

EP 17 00 1797

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

26-03-2018

| Im Recherchenbericht angeführtes Patentdokument | Datum der Veröffentlichung | Mitglied(er) der Patentfamilie | Datum der Veröffentlichung |
|---|---|---|---|
| US 2016059352 A1 | 03-03-2016 | KEINE | |
| US 2016059493 A1 | 03-03-2016 | KEINE | |
| US 2015352794 A1 | 10-12-2015 | AU 2015271638 A1<br>CN 106662439 A<br>EP 3152519 A1<br>JP 2017530027 A<br>US 2015352794 A1<br>WO 2015184495 A1 | 19-01-2017<br>10-05-2017<br>12-04-2017<br>12-10-2017<br>10-12-2015<br>10-12-2015 |
| US 2014332507 A1 | 13-11-2014 | DE 102011087374 A1<br>EP 2785481 A1<br>US 2014332507 A1<br>WO 2013079581 A1 | 29-05-2013<br>08-10-2014<br>13-11-2014<br>06-06-2013 |
| CN 104190930 A | 10-12-2014 | KEINE | |
| US 6813533 B1 | 02-11-2004 | KEINE | |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2013079581 A1